# EUROPÄISCHE PATENTSCHRIFT

(11) **EP 0 253 349 B1**
(45) Veröffentlichungstag und Bekanntmachung des Hinweises auf die Patenterteilung: **16.06.1993**
(21) Anmeldenummer: 87110093.9
(22) Anmeldetag: 13.07.1987
(51) Int. Cl.: G03F 9/00, G03F 7/20

(54) **Anordnung zur genauen gegenseitigen Ausrichtung einer Maske und einer Halbleiterscheibe in einem Lithographiegerät und Verfahren zu ihrem Betrieb**
Device for precise relative adjustment of a mask and a semiconductor wafer in a lithography apparatus and method for its use
Dispositif d'ajustement relatif exact d'un masque et d'une plaque de semi-conducteur dans un appareil de lithographie et son procédé de mise en oeuvre

(30) Priorität: 15.07.1986 DE 3623891
(43) Veröffentlichungstag der Anmeldung: 20.01.1988
(73) Patentinhaber: SIEMENS AKTIENGESELLSCHAFT, 80333 München (DE)
(72) Erfinder: Müller, Karl-Heinz, Dr., D-1000 Berlin 45 (DE)

(56) Entgegenhaltungen:
- PATENT ABSTRACTS OF JAPAN, Band 7, Nr. 204 (E-197)[1349], 9. September 1983; & JP-A-58 103 136 (NIHON KOUGAKU KOGYO K.K.) 20-06-1983
- PATENT ABSTRACTS OF JAPAN, Band 8, Nr. 169 (P-292)[1606], 4. August 1984; & JP-A-59 65 706 (HITACHI SEISAKUSHO K.K.) 14-04-1984
- IBM TECHNICAL DISCLOSURE BULLETIN, Band 25, Nr. 12, Mai 1983, Seiten 6400-6401, New York, US; G.A. FOLCHI et al.: "X-ray lithography mask alignment stage"
- J. VAC. SCI. TECHNOL. B, Band 3, Nr. 1, Januar/Februar 1985, Seiten 241-244, American Vacuum Society; K.-H. MÜLLER et al.: "Overlay measurements for x-ray lithography"

## Beschreibung

Die Erfindung bezieht sich auf eine Anordnung zur genauen gegenseitigen Ausrichtung einer Maske und einer Halbleiterscheibe in einem Lithographiegerät nach dem Oberbegriff des Anspruchs 1 und auf Verfahren zu ihrem Betrieb.

Eine Anordnung dieser Art ist dem IBM Techn. Discl. Bull. Vol. 25, No. 12, Mai 1983, Seiten 6400 und 6401, entnehmbar. Ein Lithographiegerät, bei dem eine solche Anordnung einsetzbar ist, ist z.B. im J. Vac. Sci. Technol., B3 (1), Jan./Febr. 1985, S. 241-244 beschrieben.

Üblicherweise sind auf der Maske und der Halbleiterscheibe Justiermarken vorgesehen, die über optische Einrichtungen ausgewertet und zur Ableitung von Stellsignalen verwendet werden, die eine die gegenseitige Ausrichtung durchführende Justiervorrichtung steuern. Zur einwandfreien Justierung muß der Abstand zwischen der Maske und der Halbleiterscheibe einerseits so groß gewählt werden, daß sie sich bei Ausrichtbewegungen nicht gegenseitig berühren, was zu einer Beschädigung ihrer Oberflächen und zu einer durch die auftretenden Reibungskräfte verursachten Fehljustierung führen könnte. Andererseits soll aber dieser Abstand zur Herstellung von hochintegrierten Halbleiterstrukturen, insbesondere von solchen mit einer Auflösung von 0,1 µm oder darunter, auch bei einer Belichtung der Halbleiterscheibe mit einer Röntgenstrahlung großer Parallelität hinreichend klein sein, um Beugungseffekte an den Strukturkanten praktisch auszuschließen.

Beide Forderungen können nur dann weitgehend erfüllt werden, wenn Maske und Halbleiterscheibe in der justierten Lage möglichst planparallel zueinander angeordnet sind.

Der Erfindung liegt die Aufgabe zugrunde, eine Anordnung der eingangs genannten Art anzugeben, die sowohl eine einwandfreie gegenseitige Feinjustierung von Maske und Halbleiterscheibe als auch eine möglichst hohe Auflösung der erzeugten Halbleiterstrukturen gewährleistet. Das wird erfindungsgemäß durch eine Ausbildung nach dem kennzeichnenden Teil des Anspruchs 1 erreicht.

Der mit der Erfindung erzielbare Vorteil liegt insbesondere darin, daß der aus Gründen einer Strukturverfeinerung angestrebte geringe Abstand zwischen Maske und Halbleiterscheibe wegen der erzielbaren Planparallelität zwischen diesen Teilen mit wesentlich größerer Genauigkeit eingestellt werden kann, als das bei den bisher bekannten Anordnungen der Fall ist. Die hierdurch ermöglichte Reduzierung des in kontrollierter Weise einstellbaren Abstands führt unter sonst gleichen Bedingungen zu einer Verbesserung der Strukturauflösung.

Die Ansprüche 2 bis 7 sind auf bevorzugte Ausgestaltungen und Weiterbildungen der erfindungsgemäßen Anordnung gerichtet. Die Ansprüche 8 bis 10 betreffen Verfahren zum Betrieb der erfindungsgemäßen Anordnung.

Die Erfindung wird nachfolgend anhand der Zeichnung näher erläutert. Dabei zeigt:
- Fig. 1: die schematische Darstellung eines Lithographiegeräts zur Belichtung von Halbleiterscheiben mit Röntgenstrahlung großer Parallelität,
- Fig. 2: den Längsschnitt einer nach der Erfindung ausgebildeten Maskenhalterung, die in einem Lithographiegerät nach Fig. 1 verwendet werden kann,
- Fig. 3: einen Querschnitt der Maskenhalterung nach Fig. 2 entlang der Linie III - III,
- Fig. 4: eine bevorzugte Ausgestaltung der Maskenhalterung nach den Figuren 2 und 3,
- Fig. 5: den Querschnitt eines Teils einer Halbleiterscheiben-Halterung, die eine Weiterbildung der Erfindung darstellt,
- Fig. 6: eine Ansicht dieses Teils der Halbleiterscheiben-Halterung und
- Fig. 7: eine schematische Ansicht der gesamten Halbleiterscheiben-Halterung.

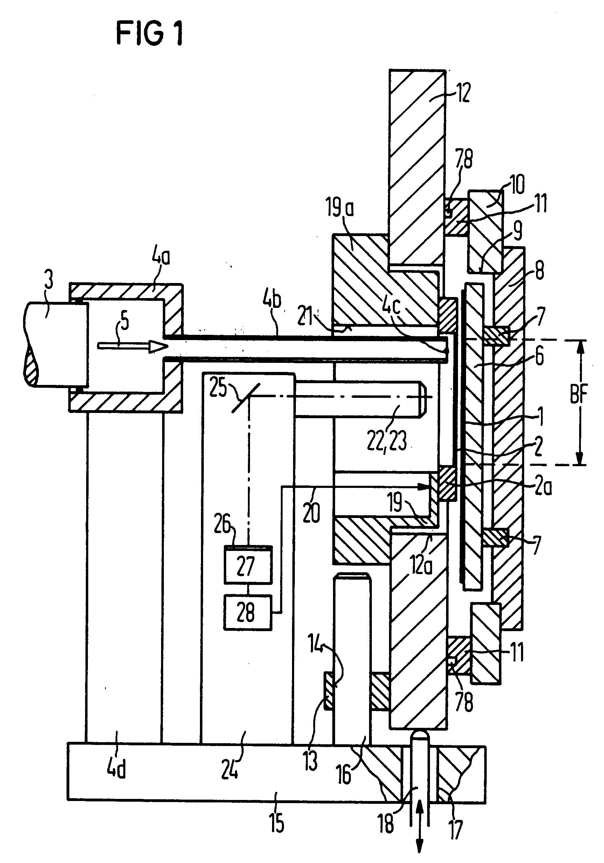

Fig. 1 zeigt ein Lithographiegerät zur Belichtung einer zu strukturierenden Halbleiterscheibe 1 unter Verwendung einer in einem vorgegebenen Abstand zu ihr gehaltenen strukturierten Maske 2 mittels einer über ein Rohr 3 zugeführten Synchrotronstrahlung. Dabei handelt es sich um eine Röntgenstrahlung hoher Parallelität, die zweckmäßigerweise aus einem Speicherring eines Elektronenbeschleunigers ausgekoppelt wird. An das Rohr 3 schließt sich eine Strahlzuführung 4 an, die aus einem zylindrischen Teil 4a und einem Ansatz 4b mit rechteckigem Querschnitt besteht, der durch ein Strahlungsfenster 4c abgeschlossen ist. Der zylindrische Teil 4a ist auf einem Sockel 4d angebracht. Die in den Teilen 3 bis 4b geführte Röntgenstrahlung wird durch den die Strahlrichtung angebenden Pfeil 5 angedeutet. Die senkrecht zur Bildebene gemessene lichte Breite der Teile 4b und 4c ist dabei größer bemessen als ihre in vertikaler Richtung gemessene lichte Höhe, so daß der Querschnitt von 4b und 4c dem Querschnitt des über 3 zugeführten Röntgenstrahlbündels angepaßt ist. Die lichte Breite kann z.B. 40 mm betragen, die lichte Höhe etwa 8 mm.

Die Halbleiterscheibe 1 ist auf einer Halteplatte 6 befestigt, die ihrerseits durch Verbindungselemente 7 an einer Einlegeplatte 8 angebracht ist. Diese wird in die Ausnehmung 9 eines Tisches 10 eingelegt und mit diesem fest verbunden. Der Tisch 10 ist seinerseits mit Abstandselementen 11 versehen, die ihn in einem vorgegebenen Abstand zu einer Tafelplatte 12 halten. Letztere befindet sich in einer zur Strahlrichtung 5 senkrechten Ebene und ist in dieser Ebene in vertikaler Richtung verschiebbar. Zu diesem Zweck ist ein Ansatz 13 der Tafelplatte mit einer Bohrung 14 versehen, die auf einem an einer Bodenplatte 15 befestigten Bolzen 16 verschiebbar gelagert ist. Ein Stift 18, der durch eine Öffnung 17 der Bodenplatte ragt und durch eine nicht dargestellte Antriebseinrichtung in Längsrichtung bewegbar ist, verschiebt die Tafelplatte und damit auch die über die Teile 6 bis 11 mit ihr verbundene Halbleiterscheibe 1 senkrecht zur Strahlrichtung 5.

Die Maske 2, die eine verstärkte Randzone 2a aufweist, ist auf einem rahmenartigen Halterungsteil 19 gelagert. Das Halterungsteil 19 ist dabei mittels eines flanschartigen Ansatzes 19a an der in Strahlrichtung vorderen Seite der Tafelplatte 12 befestigt und so ausgebildet, daß die Maske 2 zum Zwecke der Feinjustierung gegenüber der Halbleiterscheibe 1 in einer senkrecht zur Strahlrichtung 5 liegenden Ebene in zwei Koordinatenrichtungen verschiebbar und zusätzlich drehbar ist. Aus Gründen einer einfachen Darstellung ist das Halterungsteil 19, 19a in Figur 1 nicht detailliert gezeigt. Es könnte aber z.B. so beschaffen sein, wie eine aus dem IBM Techn. Discl. Bull. Vol. 25, Nr. 12, Mai 1983, S. 6400 und 6401 bekannte, gleichartige Maskenhalterung. Für das Verständnis der Figur 1 ist es ausreichend, sich vorzustellen, daß die Maske 2, 2a in der beschriebenen Weise gegenüber dem an der Tafelplatte 12 befestigten Halterungsteil 19, 19a bewegbar ist. Diese Bewegung wird durch in Figur 1 nicht dargestellte Einstellvorrichtungen bewirkt, die über Leitungen, z.B. 20, elektrisch angesteuert werden. Das rahmenartige Halterungsteil 19, 19a ragt in eine Ausnehmung 12a der Tafelplatte 12. Damit befindet sich auch die Maske 2, die eine Ausnehmung 21 des Halterungsteils 19, 19a überdeckt, innerhalb der Ausnehmung 12a bzw. in einer Lage, die hierzu in Strahlrichtung 5 versetzt ist. Ein Versatz entgegen der Strahlrichtung 5 wäre jedoch ebenso möglich.

Das Ablesen von auf der Halbleiterscheibe 1 und der Maske 2 vorhandenen Justiermarken erfolgt mit Hilfe von wenigstens zwei optischen Einrichtungen, z.B. 22 und 23, die in Figur 1 hintereinander liegen, so daß nur eine von ihnen, z.B. 22, sichtbar ist. Hierunter sind insbesondere zwei Objektive eines Mikroskops zu verstehen, das vorzugsweise in einer Säule 24 angeordnet ist und die Bilder der Justiermarken über Spiegel 25 auf den Bildschirm 26 einer Fernsehaufnahmeeinrichtung 27 überträgt. Diese leitet hiervon elektrische Signale ab, die einer elektronischen Datenverarbeitung 28 zugeführt werden. In 28 werden die erhaltenen Signale in Stellsignale verarbeitet, die den im Halterungsteil 19, 19a vorgesehenen Stellvorrichtungen über die Leitungen 20 zugeführt werden.

Mit Hilfe dieser Stellsignale erfolgt eine Feinjustierung der Lage der Maske 2 in Bezug auf die hierbei ortsfest zu denkende Halbleiterscheibe, so daß eine genaue Lageabstimmung dieser beiden Teile erreicht wird.

Das Strahlungsfenster 4c befindet sich in Strahlrichtung 5 unmittelbar vor der Maske 2, wobei es innerhalb der Ausnehmung 21 bzw. entsprechend Fig. 1 innerhalb der rahmenartig verstärkten Randzone 2a der Maske 2 ortsfest angeordnet ist. Der Abstand zwischen 4c und 2 kann z.B. 1 mm betragen. Die optischen Einrichtungen 22, 23, die neben der Strahlzuführung 4b vorgesehen und mit ihren optischen Achsen parallel zur Strahlrichtung 5 ausgerichtet sind, liegen ebenfalls im Inneren der Ausnehmung 21. Wenn man den dem Strahlungsfenster 4c gegenüberliegenden Teil der Maske bzw. der Halbleiterscheibe als Auftrefffläche bezeichnet, so sind die optischen Einrichtungen 22, 23 auf solche Teile der Maske 2 ausgerichtet, die in der in Fig. 1 dargestellten relativen Lage der Teile 1, 2 und 4 außerhalb der Auftrefffläche liegen.

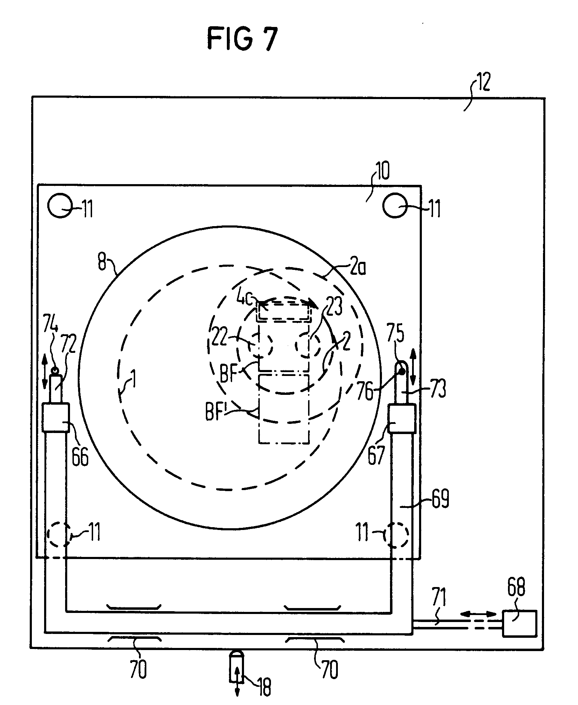

Zur Belichtung der Halbleiterscheibe 1 wird nun so vorgegangen, daß 1 zunächst gegenüber der Tafelplatte 12 und damit gegenüber der an dieser gehaltenen Maske 2 in eine solche Lage gebracht wird, daß ein bestimmtes Belichtungsfeld BF der Maske gegenüberliegt. Das geschieht in der weiter unten anhand von Figur 7 näher beschriebenen Weise. Damit befinden sich die Justiermarken der Halbleiterscheibe 1 und der Maske 2 so dicht nebeneinander, daß ihre Bilder über die optischen Einrichtungen 22, 23 aufgenommen und auf den Bildschirm 26 übertragen werden können. Die in der Einrichtung 28 abgeleiteten Stellsignale beeinflussen die Stellvorrichtungen des Halterungsteils 19, 19a dann so, daß eine genaue gegenseitige Justierung der Teile 1 und 2 erreicht wird. In der justierten Lage werden nun die Tafelplatte 12 und mit ihr die Halbleiterscheibe 1 und die Maske 2 durch eine nach oben gerichtete Bewegung des Stiftes 18 senkrecht nach oben bewegt, so daß bei Zuführung der parallelen Röntgenstrahlung 5 die Auftrefffläche allmählich von oben nach unten über das gesamte Belichtungsfeld BF verschoben wird. Diese gemeinsame Bewegung der Teile 1 und 2 am Strahlungsfenster 4c vorbei kann auch als "Scan"-Bewegung bezeichnet werden. Nach der Belichtung von BF kann dann die Halbleiterscheibe 1 vorzugsweise gegenüber der Tafelplatte 12 und damit gegenüber der Maske 2 so verstellt werden, daß der Maske ein neues Belichtungsfeld BFʹ (Fig. 7) gegenüberliegt. Diese Einstellung kann als eine "Step"-Bewegung aufgefaßt werden.

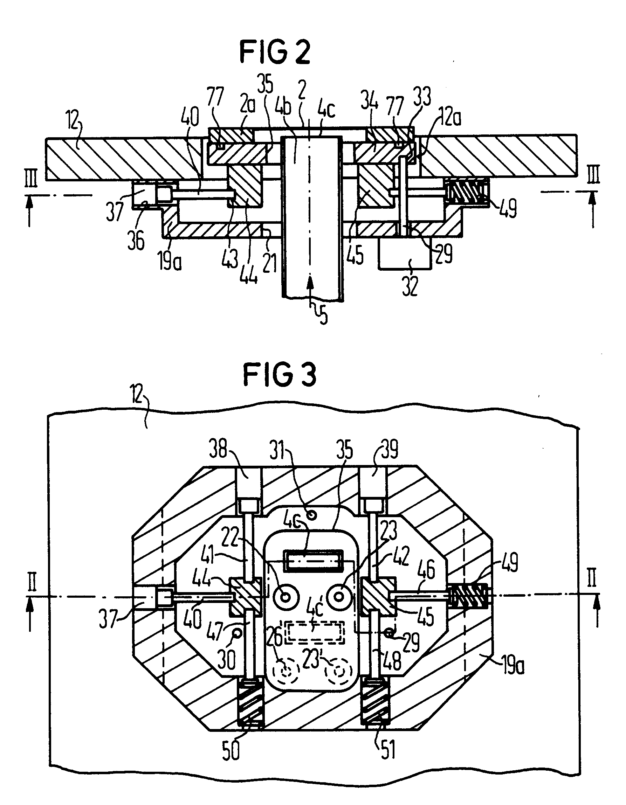

Nach der Erfindung ist nun das in Fig. 1 schematisch dargestellte und mit 19, 19a bezeichnete rahmenartige Halterungsteil so ausgebildet, daß die Maske 2, 2a sowohl senkrecht zur Strahlrichtung 5 ausgerichtet werden kann als auch innerhalb der so definierten Maskenebene mit großer Genauigkeit relativ zu der zu strukturierenden Halbleiterscheibe feinjustiert werden kann. Eine bevorzugte Ausführungsform dieses Halterungsteils ist in den Figuren 2 und 3 gezeigt. Dabei sind in dem Halterungsteil 19a, das an der Tafelplatte 12 befestigt ist, drei senkrecht zur Ebene der Maske 2 angeordnete Stellstifte 29 bis 31 in Längsrichtung verschiebbar gelagert und jeweils mit steuerbaren Antriebsvorrichtungen gekoppelt, welche an 19a angebracht sind. In der Schnittdarstellung der Fig. 2 ist die Antriebsvorrichtung für den Stellstift 29 mit dem Bezugszeichen 32 versehen. Die Stellstifte 29 bis 31 sind biegsam ausgebildet und sind mit ihren Enden in Bohrungen 33 einer Halteplatte 34 eingesteckt, auf der die Maske 2, 2a befestigt ist. Damit definieren die Stellstifte 29 bis 31 durch ihre mittels der Antriebsvorrichtungen, z.B. 32, einstellbaren Längen die Lage der Maskenebene. Die Halteplatte 34 befindet sich innerhalb der Ausnehmung 12a der Tafelplatte 12 und weist ihrerseits eine Ausnehmung 35 auf, in die der Ansatz 4b der Strahlzuführung ragt.

In weiteren Bohrungen, z.B. 36, des Halterungsteils 19a sind drei Antriebsvorrichtungen 37 bis 39 vorgesehen, deren biegsame, in Längsrichtung bewegbare, parallel zur Ebene der Maske 2 angeordnete Stellstifte 40 bis 42 mit ihren Enden in Bohrungen, z.B. 43, zweier Ansätze 44 und 45 der Halteplatte 34 eingesteckt sind. Durch eine Betätigung des Stellstiftes 40 wird die von den biegsamen Stellstiften 29 bis 31 getragene Halteplatte 34 zu Ausrichtbewegungen parallel zu einer ersten Koordinatenachse veranlaßt, durch eine Betätigung der Stellstifte 41 und 42 zu Ausrichtbewegungen parallel zu einer zweiten Koordinatenachse oder zu einer Drehbewegung. Die Drehbewegung ergibt sich bei einer gegenläufigen Bewegung der Stellstifte 41 und 42, die Ausrichtbewegung parallel zur zweiten Koordinatenachse bei einer gleichläufigen Bewegung von 41 und 42. Durch Gegenstifte 46 bis 48, die sich unter der Spannung von Druckfedern 49 bis 51 gegen die Ansätze 44 und 45 abstützen, werden die Stellstifte 40 bis 42 und damit die Halteplatte 34 in einer definierten Lage gehalten.

Durch eine entsprechende Einstellung der Stellstifte 29 bis 31 wird die Maske 2 senkrecht zur Strahlrichtung 5 ausgerichtet. Eine Betätigung der Stellstifte 40 bis 42 bewirkt dann innerhalb der auf diese Weise eingestellten Maskenebene eine Feinjustierung der Maske 2 in Bezug auf die Halbleiterscheibe 1. In Figur 3 ist weiterhin die Lage der anhand von Fig. 1 beschriebenen optischen Einrichtungen 22 und 23 relativ zum Strahlungsfenster 4c angedeutet.

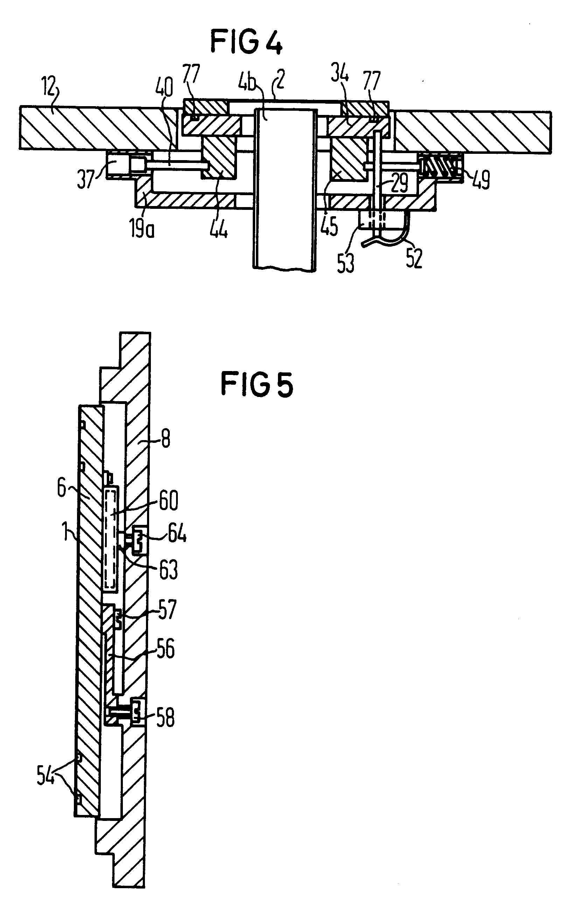

Fig. 4 zeigt eine bevorzugte Ausgestaltung der Maskenhalterung nach den Figuren 2 und 3, wobei die Antriebsvorrichtungen, z.B. 32, durch vorgespannte Blattfedern, z.B. 52, realisiert sind. Außerdem sind Klemmvorrichtungen, z.B. 53, vorgesehen, die an dem Halterungsteil 19a befestigt sind und in Klemmstellung die Stellstifte, z.B. 29, über Spannbacken mit 19a fest verbinden. Beim Lösen der Spannbacken, was vorzugsweise durch piezoelektrische Einstellelemente geschehen kann, werden die Stellstifte unter dem Einfluß der Blattfedern so bewegt, daß sich die Maske 2 der gegenüberliegenden Halbleiterscheibe 1 annähert. Die piezoelektrisch betätigbaren Spannbacken, die in der Klemmstellung diese Bewegung abstoppen, werden durch die von der elektronischen Datenverarbeitung 28 gelieferten Stellsignale gesteuert.

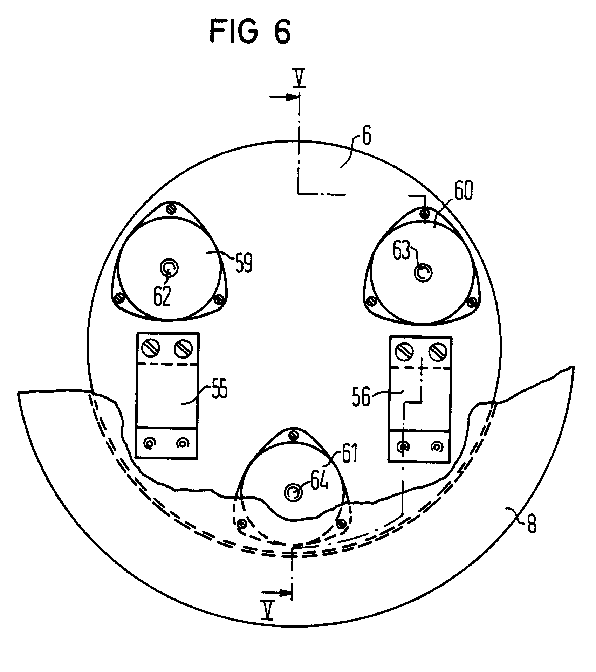

Den Figuren 5 und 6 ist eine im Rahmen der Erfindung liegende, bevorzugte Ausgestaltung der zur Halterung der Halbleiterscheibe 1 dienenden, in Fig. 1 schematisch dargestellten Teile 6, 7 und 8 entnehmbar. Dabei zeigt Fig. 5 einen Schnitt entlang der Linie V - V von Fig. 6. Die Halbleiterscheibe ist mittels einer vakuumgesteuerten Saugvorrichtung, die durch Rillen 54 angedeutet ist, auf der Halteplatte 6 befestigt. Anstelle der Saugvorrichtung können aber auch andere Befestigungsorgane verwendet werden. Die Halteplatte 6 ist nun über biegsame Verbindungselemente 55, 56 mit der Einlegeplatte 8 verbunden. Fig. 5 zeigt, daß es sich bei den Verbindungselementen 55, 56 um langgestreckte, biegsame Stege handelt, deren Enden jeweils mit Schraubverbindungen 57 und 58 an der Halteplatte 6 und an der Einlegeplatte 8 befestigt sind. Zusätzlich sind drei Antriebsvorrichtungen 59 bis 61 vorgesehen, die an der Halteplatte 6 angebracht sind und mit Stellstiften 62 bis 64 gekoppelt sind, die sich gegen Stellschrauben, z.B. 64, abstützen. Die senkrecht zur Ebene der Halbleiterscheibe 1 bewegbaren Stellstifte 62 bis 64 definieren durch ihre jeweilige Stellung die Lage der Halteplatte 6 in Bezug auf die Einlegeplatte 8. Durch eine entsprechende Ansteuerung der Antriebsvorrichtungen 59 bis 61 kann die Oberfläche der Halbleiterscheibe 1 senkrecht zur Strahlrichtung 5 ausgerichtet werden.

Fig. 7 zeigt eine Ansicht der gesamten Halterung für die Halbleiterscheibe 1 entgegen der Strahlrichtung 5. Wie hieraus hervorgeht, ist der Tisch 10, in dessen Ausnehmung die Einlegeplatte 8 mit der Halbleiterscheibe 1 eingepaßt ist, mittels Antriebsvorrichtungen 66, 67 und 68 relativ zur Tafelplatte 12 bewegbar. Mit Vorteil wird der Tisch 10 dabei zwischen der Tafelplatte 12 und einer U-förmigen Kulisse 69 gehalten, die in einer an der Tafelplatte 12 angebrachten Führung 70 horizontal verschiebbar gelagert ist. Der Antrieb der Kulisse 69 in dieser Richtung erfolgt über den Stellstift 71 der ebenfalls an 12 befestigten Antriebsvorrichtung 68. Die Stellstifte 72 und 73 der an der Kulisse befestigten Antriebsvorrichtungen 66 und 67 verschieben den Tisch 10 mittels der an ihm befestigten Stifte 74 und 75, von denen der letztere in einer Bohrung 76 des Stellstiftes 73 gehalten wird. Die Stellstifte 71, 72 und 73 sind jeweils in beiden Richtungen der eingezeichneten Doppelpfeile bewegbar. Durch die Vorrichtungen 66 bis 68 werden die erwähnten "Step"-Bewegungen erzeugt, durch die die Halbleiterscheibe 1 gegenüber der Maske 2 auf verschiedene Belichtungsfelder BF bzw. BFʹ eingestellt wird. Mit 22 und 23 sind wieder die beiden optischen Einrichtungen angedeutet, die zur Feinjustierung von Maske und Halbleiterscheibe dienen.

Zur Ausrichtung der Maske 2 senkrecht zur Strahlrichtung 5 wird nun so verfahren, daß sie mittels vakuumgesteuerter Saugvorrichtungen, die in den Figuren 2 und 4 durch Rillen 77 angedeutet sind, an der Halteplatte 34 in der in Fig. 3 gezeigten Ausgangslage befestigt wird. Dabei sind die optischen Einrichtungen 22 und 23 jeweils auf Justiermarken ausgerichtet, die sich in ersten Bereichen der Maske 2 befinden. Über 22 und 23 werden nun von den Justiermarken Stellsignale abgeleitet, die den Antriebsvorrichtungen, z.B. 32, für die Stellstifte 29 bis 31 zugeführt werden und diese veranlassen, die Maske auf die Fokussierungsebene von 22 und 23 einzustellen. Anschliessend erfolgt eine "Scan"-Bewegung der Tafelplatte 12 gemeinsam mit der an ihr gehaltenen Maske 2 durch Betätigung des Stiftes 18. Damit gelangt die Maske 2 relativ zu den Teilen 4c, 22 und 23 in eine neue Lage, die in Fig. 3 mit 4cʹ, 22ʹ und 23ʹ angedeutet ist. In dieser Lage sind die optischen Einrichtungen 22 und 23 auf zwei weitere Bereiche der Maske 2 ausgerichtet, in denen weitere Justiermarken angebracht sind. Über 22, 23, 27 und 28 werden nun weitere Stellsignale abgeleitet, die zusammen mit den in der Ausgangslage der Maske 2 abgeleiteten Stellsignalen eine genaue Ausrichtung der Maske auf die Fokussierungsebene von 22 und 23 ermöglichen. Damit ist die Ausrichtung der Maske 2 senkrecht zur Strahlrichtung 5 vollzogen.

Eine individuelle Ausrichtung der Halbleiterscheibe 1 senkrecht zur Strahlrichtung 5 kann in den Fällen unterbleiben, in denen der Keilfehler der Halbleiterscheibe 1, d.h. der Winkelfehler der Planparallelität zwischen der Vorderseite und der Rückseite von 1, ausreichend klein ist. In diesen Fällen ist die Ausrichtung der Halbleiterscheibe durch die relative Lage der Teile 10, 8 und 6 zur Tafelplatte 12 gegeben.

Ist der Keilfehler der Halbleiterscheibe aber so groß, daß er nicht mehr vernachlässigt werden kann, so wird unter Verwendung einer Halbleiterscheiben-Halterung nach den Figuren 5 und 6 in folgender Weise vorgegangen: Nach dem Befestigen der Halbleiterscheibe 1 auf der Halteplatte 6 mittels der Befestigungsorgane 54 (Fig. 5) wird die Einlegeplatte 8 in den Tisch 10 eingelegt. Dabei befindet sich die Maske 2 in aller Regel bereits in der Maskenhalterung 19a. Die Halbleiterscheibe 1 nimmt bezüglich der optischen Einrichtungen 22 und 23 eine Ausgangslage ein, die in Fig. 7 angedeutet ist. Durch transparente Stellen der Maske hindurch werden dabei auf der Halbleiterscheibe 1 angebrachte Justiermarken von den Einrichtungen 22 und 23 aufgenommen und wieder zu Stellsignalen verarbeitet, die die Antriebsvorrichtungen 59 bis 61 veranlassen, die Halbleiterscheibe auf die Fokussierungsebene von 22 und 23 einzustellen. Anschließend erfolgt eine "Scan"-Bewegung der Tafelplatte 12 gemeinsam mit der an ihr gehaltenen Halbleiterscheibe 1 durch Betätigung des Stiftes 18. Dabei gelangt die Halbleiterscheibe relativ zu den Einrichtungen 22 und 23 in eine neue Lage. In dieser sind die Einrichtungen 22 und 23 auf zwei weitere Bereiche der Halbleiterscheibe 1 ausgerichtet, in denen weitere Justiermarken angebracht sind. Über 22, 23, 27 und 28 werden jetzt weitere Stellsignale abgeleitet, die zusammen mit den in der Ausgangslage von 1 abgeleiteten Stellsignalen eine genaue Ausrichtung von 1 auf die Fokussierungsebene von 22 und 23 ermöglichen. Damit ist dann die Halbleiterscheibe 1 genau senkrecht zur Strahlrichtung 5 ausgerichtet.

Bei einer nach Fig. 4 ausgebildeten Maskenhalterung und einer nach den Figuren 5 und 6 ausgebildeten Halbleiterscheiben-Halterung kann die genaue Ausrichtung der Maske auch in der Weise erfolgen, daß die von ihren Justiermarken abgeleiteten Stellsignale nur zur Steuerung der Antriebsvorrichtungen 59 bis 61 herangezogen werden. Eine von den Justiermarken abhängige Steuerung der Klemmvorrichtungen 53 entfällt dabei. Ein solches Ausrichtverfahren läuft wie folgt ab. Zunächst wird die Maske 2 mittels der Befestigungsorgane 54 an der Halteplatte 6 zwischenbefestigt. Nach dem Einlegen von 8 in den Tisch 10 befindet sich die Maske relativ zu den Teilen 4c, 22 und 23 in der in Fig. 3 angedeuteten Ausgangslage. Auf der Maske 2 angebrachte Justiermarken werden über 22, 23, 27 und 28 zu Stellsignalen verarbeitet, die die Antriebseinrichtungen 59 bis 61 veranlassen, die Maske 2 auf die Fokussierungsebene von 22 und 23 einzustellen. Anschliessend erfolgt eine "Scan"-Bewegung der Tafelplatte 12 gemeinsam mit der an ihr gehaltenen Maske 2 durch Bewegung des Stiftes 18. Dabei gelangt die Maske 2 relativ zu den Einrichtungen 22 und 23 in die neue Lage, die in Fig. 3 durch die Bezugszeichen 4cʹ, 22ʹ und 23 ʹ gekennzeichnet ist. In dieser Lage sind die Einrichtungen 22 und 23 auf die weiteren Bereiche der Maske 2 ausgerichtet, in denen die weiteren Justiermarken angebracht sind. Über 22, 23, 27 und 28 werden dann weitere Stellsignale abgeleitet, die zusammen mit den in der Ausgangslage der Maske 2 abgeleiteten Stellsignalen eine genaue Ausrichtung der Maske 2 auf die Fokussierungsebene von 22 und 23 ermöglichen.

Nachdem die Maske 2 in dieser Weise senkrecht zur Strahlrichtung 5 ausgerichtet worden ist, werden die Klemmvorrichtungen 53 veranlaßt, die Einstellstifte 29 bis 31 freizugeben. Unter der Wirkung der Blattfedern, z.B. 52, bewegt sich hierbei die Halteplatte 34 in Richtung auf die an der Halteplatte 6 zwischenbefestigte, ausgerichtete Maske 2 und kontaktiert diese schließlich. Im Anschluß hieran werden die Klemmvorrichtungen 53 wieder in die Klemmstellung gebracht und die Befestigungselemente 77 so angesteuert, daß die Maske 2 an der Halteplatte 34 befestigt wird, worauf die Befestigungselemente 54 veranlaßt werden, die Verbindung zwischen 2 und 6 zu lösen. Damit wird die justierte Maske 2 von der Halteplatte 6 an die Halteplatte 34 übergeben. Anschließend wird eine Halbleiterscheibe an der Halteplatte 6 befestigt und gegebenenfalls mittels der oben beschriebenen individuellen Ausrichtung in eine definierte Lage senkrecht zur Strahlrichtung 5 gebracht.

Zweckmäßigerweise bestehen die Antriebsvorrichtungen 32, 37 bis 39 und 59 bis 61 aus an sich bekannten piezoelektrischen Einstellelementen. Die am Tisch 10 befestigten Abstandselemente 11 können vorzugsweise mit vakuumgesteuerten Saugvorrichtungen versehen sein, die in Fig. 1 durch Rillen 78 angedeutet sind. Durch den Aufbau eines Vakuums in den Rillen 78 werden dabei die Tafelplatte 12 und der Tisch 10 miteinander verklammert. Das geschieht nach der Grobjustierung von Maske 2 und Halbleiterscheibe 1 mittels der Antriebsvorrichtungen 66 bis 68 und vor der Feinjustierung mittels der Antriebsvorrichtungen 32, 37 bis 39 und gegebenenfalls 59 bis 61. Auch während der Belichtung der Halbleiterscheibe 1 bleibt die feste Verbindung der Teile 10 und 12 bestehen. Die durch die Rillen 54 und 77 angedeuteten, vakuumgesteuerten Saugvorrichtungen werden in der gleichen Weise betrieben, um die Maske 2 bzw. die Halbleiterscheibe an den Halteplatten 34 bzw. 6 zu befestigen.

### Bezugszeichenliste

- 1: Halbleiterscheibe
- 2: Maske
- 2a: Randzone von 2
- 3: Rohr
- 4a: zylindrischer Teil einer Strahlzuführung
- 4b: Ansatz von 4a
- 4c: Strahlungsfenster
- 4d: Sockel
- 5: Strahlrichtung
- 6: Halteplatte
- 7: Verbindungselemente
- 8: Einlegeplatte
- 9: Ausnehmung
- 10: Tisch
- 11: Abstandselemente
- 12: Tafelplatte
- 13: Ansatz von 12
- 14: Bohrung
- 15: Bodenplatte
- 16: Bolzen
- 17: Öffnung von 15
- 18: Stift
- 19: Halterungsteil
- 19a: Ansatz von 19
- 20: Leitungen
- 21: Ausnehmung von 19
- 22, 23: optische Einrichtungen
- 24: Säule
- 25: Spiegel
- 26: Bildschirm
- 27: Fernsehaufnahmevorrichtung
- 28: elektronische Datenverarbeitung
- 29 bis 31: Stellstifte
- 32: Antriebsvorrichtung
- 33: Bohrungen von 34
- 34: Halteplatte
- 35: Ausnehmung von 34
- 36: Bohrungen von 19a
- 37 bis 39: Antriebsvorrichtungen
- 40 bis 42: Stellstifte
- 43: Bohrungen von 44, 45
- 44, 45: Ansätze von 34
- 46 bis 48: Gegenstifte
- 49 bis 51: Druckfedern
- 52: Blattfeder
- 53: Klemmvorrichtung
- 54: Rillen
- 55, 56: Verbindungselemente
- 57, 58: Schraubverbindungen
- 59 bis 61: Antriebsvorrichtungen
- 62 bis 64: Stellstifte
- 66 bis 68: Antriebsvorrichtungen
- 69: Kulisse
- 70: Führung
- 71, 72, 73: Stellstifte
- 74, 75: Stellstifte
- 76: Bohrung von 73
- 77, 78: Rillen

## Patentansprüche

1. Anordnung zur genauen gegenseitigen Ausrichtung einer Maske (2) und einer Halbleiterscheibe (1) in einem Lithographiegerät,
- bei der ein paralleler Korpuskularstrahl oder Röntgenstrahl auf die strukturierte Maske (2) und auf die unmittelbar und im Abstand in Richtung des Strahls dahinterliegende, zu strukturierende Halbleiterscheibe (1) auftrifft,
- bei der die Maske (2) mittels erster Befestigungsorgane (77) auf einer ersten Halteplatte (34) befestigbar ist, die in einem an einer Tafelplatte (12) befestigten, rahmenartigen Halterungsteil (19a) mittels dreier erster, senkrecht zur Ebene der Maske angeordneter Stellstifte (29 bis 31) gelagert ist, und
- bei der drei zweite, parallel zur Ebene der Maske angeordnete Stellstifte (40 bis 42) vorgesehen sind, von denen einer (40) Ausrichtbewegungen der ersten Halteplatte (34) parallel zu einer ersten Koordinatenachse (X) und die beiden anderen (41, 42) Ausrichtbewegungen derselben parallel zu einer zweiten Koordinatenachse (Y) oder eine Drehbewegung veranlassen, wobei die zweiten Stellstifte (40 bis 42) über am Halterungsteil (19a) befestigte erste Antriebsvorrichtungen (37 bis 39) jeweils in Längsrichtung verschiebbar sind,
**dadurch gekennzeichnet,** daß die ersten Stellstifte (29 bis 31) im Halterungsteil (19a) in Längsrichtung verschiebbar gelagert und mit zweiten, am Halterungsteil (19a) befestigten, steuerbaren Antriebsvorrichtungen (32) gekoppelt sind.

2. Anordnung nach Anspruch 1, **dadurch gekennzeichnet,** daß die zweiten Antriebsvorrichtungen (32) aus vorgespannten Federn (52) bestehen und daß steuerbare Klemmelemente (53) vorgesehen sind, die die ersten Stellstifte (29) in jeder beliebigen Stellung mit dem Halterungsteil (19a) fest verbinden.

3. Anordnung nach einem der Ansprüche 1 oder 2, **dadurch gekennnzeichnet,** daß die Halbleiterscheibe (1) mittels zweiter Befestigungsorgane (54) auf einer zweiten Halteplatte (6) befestigbar ist, die über biegsame Verbindungselemente (55, 56) mit einer Einlegeplatte (8) verbunden ist, daß drei dritte, über dritte, steuerbare Antriebsvorrichtungen (59 bis 61) betätigbare Stellstifte (62 bis 64) vorgesehen sind, die jeweils senkrecht zur Ebene der Halbleiterscheibe (1) bewegbar sind und die gegenseitige Lage der zweiten Halteplatte (6) und der Einlegeplatte (8) bestimmen, und daß die Einlegeplatte (8) in die Ausnehmung (9) eines Tisches (10) einlegbar ist, der in einer auf der Tafelplatte (12) befestigten Halterungsvorrichtung (69,70) gelagert ist, wobei die Halterungsvorrichtung insbesondere so ausgebildet ist, daß eine grobe Ausrichtung der Halbleiterscheibe (1) relativ zum Korpuslularstrahl oder Röntgenstrahl durch eine Translations- und Drehbewegung des Tisches (10) erfolgt.

4. Anordnung nach Anspruch 3, **gekennzeichnet durch** die Abwandlung, daß anstelle der Halbleiterscheibe (1) die Maske (2) mittels der zweiten Befestigungsorgane (54) auf der zweiten Halteplatte befestigbar ist.

5. Anordnung nach einem der Ansprüche 1 bis 4, **dadurch gekennzeichnet,** daß die Tafelplatte (12) gemeinsam mit dem Halterungsteil (19a) und gegebenenfalls mit der Halterungsvorrichtung (69, 70) senkrecht zur Richtung des Korpuskularstrahls oder Röntgenstrahls bewegbar angeordnet ist, daß zwei strahlparallel orientierte orientierte und seitlich zur Bewegungsrichtung der Tafelplatte (12) gegeneinander versetzte, optische Einrichtungen (22, 23) vorgesehen sind und daß auf der Maske (2) und/oder der Halbleiterscheibe (1) vorhandene Justiermarken über die optischen Einrichtungen (22, 23) ausgewertet und zur Ableitung von Stellsignalen verwendet werden, die die Antriebsvorrichtungen (32, 37 bis 39, 59 bis 61) steuern.

6. Anordnung nach einem der vorhergehenden Ansprüche, **dadurch gekennzeichnet,** daß die Befestigungsorgane (54, 77) aus vakuumgesteuerten Saugvorrichtungen bestehen.

7. Anordnung nach einem der vorhergehenden Ansprüche, **dadurch gekennzeichnet,** daß die Antriebsvorrichtungen (32, 37 bis 39, 59 bis 61) aus piezoelektrischen Stelleinrichtungen bestehen.

8. Verfahren zur Ausrichtung der Maske (2) senkrecht zur Richtung des Korpuskularstrahls oder Röntgenstrahls unter Verwendung der Anordnung nach Anspruch 5, **dadurch gekennzeichnet,** daß die Maske (2) mittels der ersten Befestigungsorgane (77) auf der ersten Halteplatte (34) befestigt wird, daß erste Justiermarken der Maske (2) in einer ersten Lage der Tafelplatte (12) zur Ableitung von Stellsignalen verwendet werden, die zur Einstellung der Maske (2) auf die Fokussierungsebene der beiden optischen Einrichtungen (22, 23) dienen, und daß die Tafelplatte (12) sodann senkrecht zur Richtung des Korpuskularstrahls oder Röntgenstrahls in eine zweite Lage verschoben wird, worauf zweite Justiermarken der Maske (2) zur Ableitung von weiteren Stellsignalen verwendet werden, die zur Einstellung der Maske (2) auf diese Fokussierungsebene dienen.

9. Verfahren zur Ausrichtung der Maske (1) senkrecht zur Richtung des Korpuskularstrahls oder Röntgenstrahls unter Verwendung der Anordnung nach Anspruch 5, **dadurch gekennzeichnet,** daß die Maske (2) mittels der zweiten Befestigungsorgane (54) auf der zweiten Halteplatte (6) befestigt wird, daß erste Justiermarken der Maske (2) in einer ersten Lage der Tafelplatte (12) zur Ableitung von Stellsignalen verwendet werden, die zur Einstellung der Maske (2) auf die Fokussierungsebene der beiden optischen Einrichtungen (22, 23) dienen, daß die Tafelplatte (12) sodann senkrecht zur Richtung des Korpuskularstrahls oder Röntgenstrahls in eine zweite Lage verschoben wird, worauf zweite Justiermarken der Maske (2) zur Ableitung von weiteren Stellsignalen verwendet werden, die zur Einstellung der Maske (2) auf diese Fokussierungsebene dienen, und daß die Maske (2) anschließend durch Lösen der Klemmelemente (53) in Kontakt mit der ersten Halteplatte (34) gebracht wird, worauf die ersten (77) und zweiten (54) Befestigungsorgane derart gesteuert werden, daß die Maske (2) auf der ersten Halteplatte (34) befestigt und sodann von der zweiten Halteplatte (6) gelöst wird.

10. Verfahren nach Anspruch 8 oder 9, **dadurch gekennzeichnet,** daß zur Ausrichtung der Halbleiterscheibe (1) senkrecht zur Richtung des Korpuskularstrahls oder Röntgenstrahls die Halbleiterscheibe (1) mittels der zweiten Befestigungsorgane (54) auf der zweiten Halteplatte (6) befestigt wird, daß erste Justiermarken der Halbleiterscheibe (1) in einer ersten Lage der Tafelplatte (12) zur Ableitung von Stellsignalen verwendet werden, die zur Einstellung der Halbleiterscheibe (1) auf die Fokussierungsebene der beiden optischen Einrichtungen (22, 23) dienen, und daß die Tafelplatte (12) senkrecht zur Richtung des Korpuskularstrahls oder Röntgenstrahls in eine zweite Lage verschoben wird, worauf zweite Justiermarken der Halbleiterscheibe (1) zur Ableitung von weiteren Stellsignalen verwendet werden, die zur Einstellung der Halbleiterscheibe (1) auf diese Fokussierungsebene dienen.

## Claims

1. Arrangement for the exact mutual alignment of a mask (2) and a semiconductor wafer (1) in a lithographic unit,
- in which a parallel particle beam or X-ray impinges upon the configured mask (2) and upon the semiconductor wafer (1) to be configured which lies directly behind this at a distance therefrom in the direction of the ray;
- in which the mask (2), by means of first securing parts (77), can be secured to a first holding plate (34) which, by means of three first adjusting pins (29 to 31) which are arranged perpendicularly to the plane of the mask, is mounted in a frame-like supporting portion (19a) secured to a panel plate (12); and
- in which there are provided three second adjusting pins (40 to 42) which are arranged parallel to the plane of the mask and of which one (40) causes aligning movements of the first holding plate (34) parallel to a first coordinate axis (X) and the other two (41, 42) cause aligning movements of the same, parallel to a second coordinate axis (Y), or a rotating movement, with the second adjusting pins (40 to 42) each being displaceable in the longitudinal direction by way of first driving arrangements (37 to 39) secured to the supporting portion (19a),
characterised in that the first adjusting pins (29 to 31) are mounted in the supporting portion (19a) so as to be displaceable in the longitudinal direction and are coupled with second controllable driving arrangements (32) which are secured to the supporting portion (19a).

2. Arrangement according to claim 1, characterised in that the second driving arrangements (32) consist of pretensioned springs (52) and in that controllable clamping elements (53) are provided which fixedly connect the first adjusting pins (29) in any position with the supporting portion (19a).

3. Arrangement according to one of the claims 1 or 2, characterised in that the semiconductor wafer (1) can be secured, by means of second securing parts (54), to a second holding plate (6) which is connected with an insert plate (8) by way of flexible connecting elements (55, 56), in that there are provided three third adjusting pins (62 to 64) which can be actuated by way of third controllable driving arrangements (59 to 61) and which can be moved in each case perpendicularly to the plane of the semiconductor wafer (1) and determine the mutual position of the second holding plate (6) and the insert plate (8) and in that the insert plate (8) can be inserted into the recess (9) of a table (10) which is mounted in a supporting arrangement (69, 70) which is secured to the panel plate (12), with the supporting arrangement being formed in particular so that rough alignment of the semiconductor wafer (1) occurs relative to the particle beam or X-ray as a result of a translational and rotating movement of the table (10).

4. Arrangement according to claim 3, characterised by the modification that instead of the semiconductor wafer (1) the mask (2) can be secured to the second holding plate by means of the second securing parts (54).

5. Arrangement according to one of the claims 1 to 4, characterised in that the panel plate (12) is arranged together with the supporting portion (19a) and, if applicable, with the supporting arrangement (69, 70) so as to be movable perpendicularly to the direction of the particle beam or X-ray, in that there are provided two optical devices (22, 23) which are orientated so as to be parallel to the ray and which are staggered laterally relative to the direction of movement of the panel plate (12) and in that adjustment marks present on the mask (2) and/or the semiconductor wafer (1) are evaluated by way of the optical devices (22, 23) and are used to derive adjustment signals which control the driving arrangements (32, 37 to 39, 59 to 61).

6. Arrangement according to one of the preceding claims, characterised in that the securing parts (54, 77) consist of vacuum-controlled suction arrangements.

7. Arrangement according to one of the preceding claims, characterised in that the driving arrangements (32, 37 to 39, 59 to 61) consist of piezoelectric adjusting devices.

8. Method for aligning the mask (2) perpendicularly to the direction of the particle beam or X-ray with use of the arrangement according to claim 5, characterised in that the mask (2) is secured to the first holding plate (34) by means of the first securing parts (77), in that first adjustment marks of the mask (2) are used in a first position of the panel plate (12) to derive adjustment signals which are used to adjust the mask (2) to the focusing plane of the two optical devices (22, 23) and in that the panel plate (12) is then displaced into a second position perpendicularly to the direction of the particle beam or X-ray, whereupon second adjustment marks of the mask (2) are used to derive further adjustment signals which are used to adjust the mask (2) to this focusing plane.

9. Method for aligning the mask (1) (sic) perpendicularly to the direction of the particle beam or X-ray with use of the arrangement according to claim 5, characterised in that the mask (2) is secured to the second holding plate (6) by means of the second securing parts (54), in that first adjustment marks of the mask (2) are used in a first position of the panel plate (12) to derive adjustment signals which are used to adjust the mask (2) to the focusing plane of the two optical devices (22, 23), in that the panel plate (12) is then displaced into a second position perpendicularly to the direction of the particle beam or X-ray, whereupon second adjustment marks of the mask (2) are used to derive further adjustment signals which are used to adjust the mask (2) to this focusing plane and in that the mask (2) is subsequently brought into contact with the first holding plate (34) by releasing the clamping elements (53), whereupon the first (77) and second (54) securing parts are controlled in such a way that the mask (2) is secured to the first holding plate (34) and is then released from the second holding plate (6).

10. Method according to claim 8 or 9, characterised in that for the purpose of aligning the semiconductor wafer (1) perpendicularly to the direction of the particle beam or X-ray the semiconductor wafer (1) is secured to the second holding plate (6) by means of the second securing parts (54), in that first adjustment marks of the semiconductor wafer (1) are used in a first position of the panel plate (12) to derive adjustment signals which are used to adjust the semiconductor wafer (1) to the focusing plane of the two optical devices (22, 23) and in that the panel plate (12) is displaced into a second position perpendicularly to the direction of the particle beam or X-ray, whereupon second adjustment marks of the semiconductor wafer (1) are used to derive further adjustment signals which are used to adjust the semiconductor wafer (1) to this focusing plane.

## Revendications

1. Dispositif pour réaliser l'alignement réciproque précis d'un masque (2) et d'une pastille semiconductrice (1) dans un appareil de lithographie, et dans lequel
- un faisceau corpusculaire ou un faisceau de rayons X parallèle rencontre le masque structuré (2) et la pastille semiconductrice devant être structurée (1) qui est située directement derrière le masque, à distance dans la direction du faisceau,
- le masque (2) peut être fixé au moyen des premiers éléments de fixation (77) sur une première plaque de support (34), qui est montée dans une pièce de support en forme de cadre (19a), qui est fixée à une plaque en forme de tableau (12), au moyen de trois premières tiges de réglage (29 à 31) disposées perpendiculairement au plan du masque, et
- il est prévu trois secondes tiges de réglage (40 à 42), qui sont parallèles au plan du masque et dont l'une (40) déclenche des déplacements d'alignement de la première plaque de support (34) parallèlement à un premier axe de coordonnées (X) tandis que les deux autres (41,42) déclenchent des déplacements d'alignement de la même plaque parallèlement à un second axe de coordonnées (Y) ou un mouvement de rotation, les secondes tiges de réglage (40 à 42) étant déplaçables respectivement dans la direction longitudinale par l'intermédiaire de premiers dispositifs d'entraînement (37 à 39), fixés sur la pièce de support (19a),
caractérisé par le fait que les premières tiges de réglage (29 à 31) sont montées de manière à être déplaçables dans la direction longitudinale dans la pièce de support (19a) et sont accouplées à des seconds dispositifs d'entraînement commandables (32), fixés à la pièce de support (19a).

2. Dispositif suivant la revendication 1, caractérisé par le fait que les seconds dispositifs d'entraînement (32) sont constitués par des ressorts précontraints (52) et qu'il est prévu des éléments de serrage commandables (53), qui raccordent de façon fixe les premières tiges de réglage (29), dans n'importe quelle position, à la pièce de support (19a).

3. Dispositif suivant l'une des revendications 1 ou 2, caractérisé par le fait que la pastille semiconductrice (1) peut être fixée au moyen de deux éléments de fixation (54) sur une seconde plaque de fixation (6), qui est raccordée à une plaque d'insertion (8) par l'intermédiaire d'éléments de liaison flexibles (55,56), qu'il est prévu trois troisièmes tiges de réglage (62 à 64), qui peuvent être actionnées par l'intermédiaire de troisièmes dispositifs d'entraînement commandables (59 à 61), qui sont déplaçables respectivement perpendiculairement au plan de la pastille semiconductrice (1) et qui déterminent la position réciproque de la seconde plaque de fixation (6) et de la plaque d'insertion (8), et que la plaque d'insertion (8) peut être insérée dans l'évidement (9) d'une table (10), qui est supportée dans un dispositif de support (69,70) fixé à la plaque formant tableau (12), le dispositif de support étant agencé notamment de manière à obtenir un alignement grossier de la plaquette semiconductrice (1) par rapport au faisceau corpusculaire ou au faisceau de rayons X au moyen d'un mouvement de translation et de rotation de la table (10).

4. Dispositif suivant la revendication 3, caractérisé par la variante selon laquelle au lieu de la pastille semiconductrice (1), on peut fixer le masque (2) à la seconde plaque de support au moyen des seconds éléments de fixation (54).

5. Dispositif suivant l'une des revendications 1 à 4, caractérisé par le fait que la plaque formant tableau (12) est montée de manière à être déplaçable conjointement avec la partie de fixation (19a) et éventuellement avec le dispositif de fixation (69,70), perpendiculairement à la direction du faisceau corpusculaire ou du faisceau de rayons X, qu'il est prévu deux dispositifs optiques (22,23), qui sont orientés parallèlement au faisceau et qui sont décalés réciproquement latéralement par rapport à la direction de déplacement de la plaque formant tableau (12), et que des marques d'ajustement présentes sur le masque (2) et/ou sur la pastille semiconductrice (1) sont évaluées par l'intermédiaire des dispositifs optiques (22,23) et sont utilisées pour dériver des signaux de réglage, qui commandent les dispositifs d'entraînement (32,37 à 39,59 à 61).

6. Dispositif suivant l'une des revendications précédentes, caractérisé par le fait que les éléments de fixation (54,77) sont constitués par des dispositifs de succion commandés par un vide.

7. Dispositif suivant l'une des revendications précédentes, caractérisé par le fait que les dispositifs d'entraînement (32,37 à 39,59 à 61) sont constitués par des dispositifs de réglage piézoélectrique.

8. Procédé pour aligner le masque (2) perpendiculairement à la direction du faisceau corpusculaire ou du faisceau de rayons X moyennant l'utilisation du dispositif selon la revendication 5, caractérisé par le fait qu'on fixe le masque (2) au moyen des premiers éléments de fixation (77) sur une première plaque de retenue (34), qu'on utilise des premières marques d'ajustement du masque (2) dans une première position de la plaque formant tableau (12) pour obtenir des signaux de réglage qui sont utilisés pour régler le masque (2) sur le plan de focalisation des deux dispositifs optiques (22,23), et qu'on déplace la plaque formant tableau (12) perpendiculairement à la direction du faisceau corpusculaire ou du faisceau de rayons X pour l'amener dans une seconde position, à la suite de quoi on utilise des secondes marques d'ajustement du masque (2) pour obtenir d'autres signaux de réglage, qui servent à régler le masque (2) sur ce plan de focalisation.

9. Procédé pour aligner le masque (2) perpendiculairement à la direction du faisceau corpusculaire ou du faisceau de rayons X moyennant l'utilisation du dispositif suivant la revendication 5, caractérisé par le fait qu'on fixe le masque (2) au moyen des seconds éléments de fixation (54) sur la seconde plaque de fixation (6), qu'on utilise des premières marques d'ajustement du masque (2) dans une première couche de la plaque formant plateau (12) pour obtenir des signaux de réglage qui sont utilisés pour régler le masque (2) sur le plan de focalisation des deux dispositifs optiques (22,23), qu'on déplace la plaque formant tableau (12) perpendiculairement à la direction du faisceau corpusculaire ou du faisceau de rayons X pour l'amener dans une seconde position, à la suite de quoi on utilise des secondes marques d'ajustement du masque (2) pour obtenir d'autres signaux de réglage, qui sont utilisés pour régler le masque (2) sur ce plan de focalisation, et qu'on amène ensuite le masque (2), par desserrage des éléments de serrage (53), en contact avec la première plaque de fixation (34), à la suite de quoi on commande les premiers éléments de fixation (77) et les seconds éléments de fixation (64) de manière à fixer le masque (2) sur la première plaque de fixation (34) et à le détacher ensuite de la seconde plaque de fixation (6).

10. Procédé suivant la revendication 8 ou 9, caractérisé par le fait que pour l'alignement de la pastille semiconductrice (1) perpendiculairement à la direction du faisceau corpusculaire ou du faisceau de rayons X, on fixe la pastille semiconductrice (1) au moyen des seconds éléments de fixation (54) sur la seconde plaque de fixation (6), qu'on utilise des premières marques d'ajustement de la pastille semiconductrice (1) dans la première position de la plaque formant tableau (12) pour obtenir des signaux de réglage, qu'on utilise pour régler la pastille semiconductrice (1) sur le plan de focalisation des deux dispositifs optiques (22,23) et qu'on déplace la plaque formant tableau (12) perpendiculairement à la direction du faisceau corpusculaire ou du faisceau de rayons X pour l'amener dans une seconde position, à la suite de quoi on utlise des seconds masques d'ajustement de la pastille semiconductrice (1) pour obtenir d'autres signaux de réglage, qui sont utilisés pour régler la pastille semiconductrice (1) sur ce plan de focalisation.
